# EUROPEAN PATENT APPLICATION

(11) **EP 4 184 182 A1**
(43) Date of publication of application: **24.05.2023**
(21) Application number: 22208035.0
(22) Date of filing: 17.11.2022
(51) Int. Cl.: G01R 19/25, G01R 31/28, G01R 31/40, G01R 31/52, G01R 31/54

(54) **CONTROL APPARATUS AND BATTERY PACK**

(30) Priority: 17.11.2021 JP 2021186868
(71) Applicant: Envision AESC Japan Ltd., Zama-shi, Kanagawa 252-0012 (JP)
(72) Inventor: TADA, Motoki, Zama-Shi 252-0012 (JP)
(74) Representative: Mathys & Squire

(57) **Abstract**

A control apparatus (10) controls a relay (20). The control apparatus (10) includes a control element (12), a monitoring circuit (14), and a determination unit (16). An input signal Vi is input to the control element (12). The control element (12) outputs an output signal Vo and a diagnostic signal Vd. The monitoring circuit (14) generates an output monitor signal Vm indicating the level of the output signal Vo. The determination unit (16) determines whether or not the control apparatus (10) has an abnormality, based on a relationship between the output monitor signal Vm and the diagnostic signal Vd. Here, the output signal Vo is a signal for driving the relay (20). One terminal of the monitoring circuit (14) is electrically connected to an output terminal of the control element (12) for the output signal Vo. The diagnostic signal Vd is a signal for monitoring the state of an output destination of the output signal Vo.

## Description

### BACKGROUND

### TECHNICAL FIELD

The present invention relates to control of relays.

### RELATED ART

A battery pack in which a plurality of batteries are connected is used to supply power to various loads. At this time, a relay is disposed between the battery and the load, and ON/OFF of the relay is controlled by a relay drive circuit.

Here, some control elements used in a drive circuit can diagnose the state of an output destination of a signal. By diagnosing the state of the output destination, it is possible to detect whether the relay has failed.

Japanese Unexamined Patent Publication No. 2007-27465 discloses that, in a drive circuit of a linear solenoid, that includes an asymmetrical bridge, two diagnostic results are input to a control unit, and operation states of an asymmetrical half-bridge circuit and the linear solenoid are determined based on the diagnostic results.

Japanese Unexamined Patent Publication No. 2007-255413 discloses that an abnormality in a load driving system is diagnosed based on a result obtained by comparing a control signal input to a driver and a monitor signal output from an abnormality detection unit.

### SUMMARY

However, there is room for improving the reliability of a control apparatus of the relay. For example, in the technique in Japanese Unexamined Patent Publication No. 2007-27465, the failure of an intelligent power switch is not assumed. In addition, in the technique in Japanese Unexamined Patent Publication No. 2007-255413, the output signal from the driver to the load is not monitored.

The present invention has been made in view of the above problems. An object of the present invention to provide a technique for improving the reliability of abnormality detection in a control apparatus of a relay.

In one embodiment, there is provided a first control apparatus that is a control apparatus that controls a relay. The control apparatus includes a control element that receives an input signal and outputs an output signal and a diagnostic signal, a monitoring circuit that generates an output monitor signal indicating the level of the output signal, and a determination unit that determines whether or not the control apparatus has an abnormality, based on a relationship between the output monitor signal and the diagnostic signal.

The output signal is a signal for driving the relay.

One terminal of the monitoring circuit is electrically connected to an output terminal of the control element for the output signal.

The diagnostic signal is a signal for monitoring the state of the output destination of the output signal.

In another embodiment, there is provided a first battery pack that is a battery pack including the control apparatus as described above, a battery, and the relay.

According to the present invention, it is possible to provide a technique for improving the reliability of abnormality detection in a control apparatus of a relay.

### BRIEF DESCRIPTION OF THE DRAWINGS

The above and other objects, advantages and features of the present invention will be more apparent from the following description of certain preferred embodiments taken in conjunction with the accompanying drawings, in which:
Fig. 1 is a block diagram illustrating a functional configuration of a control apparatus according to a first embodiment.
Fig. 2 is a diagram illustrating a hardware configuration of the control apparatus according to the first embodiment.
Fig. 3 is a diagram illustrating a hardware configuration of an integrated circuit.
Fig. 4 is a table illustrating a relationship of each signal in a normal control apparatus.
Fig. 5 is a table obtained by adding the relationship of each signal when a control element has an abnormality, and a diagnostic signal is not correctly output, to the table in Fig. 4.
Fig. 6 is a table obtained by adding the relationship of each signal when a monitoring circuit has an abnormality, and an output monitor signal is not correctly output, to the table in Fig. 4.
Fig. 7 is a block diagram illustrating a functional configuration of a battery pack according to the first embodiment.
Fig. 8 is a diagram illustrating a configuration of a battery pack according to a second embodiment.
Fig. 9 is a diagram illustrating a configuration of a control apparatus according to the second embodiment.

### DETAILED DESCRIPTION

The invention will be now described herein with reference to illustrative embodiments. Those skilled in the art will recognize that many alternative embodiments can be accomplished using the teachings of the present invention and that the invention is not limited to the embodiments illustrated for explanatory purposes.

Hereinafter, embodiments of the present invention will be described with reference to the drawings. In all drawings, similar components are denoted by the similar reference signs, and description thereof will not be repeated.

### First Embodiment

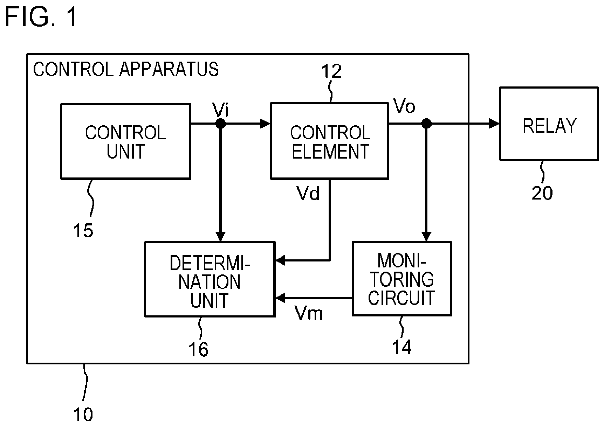

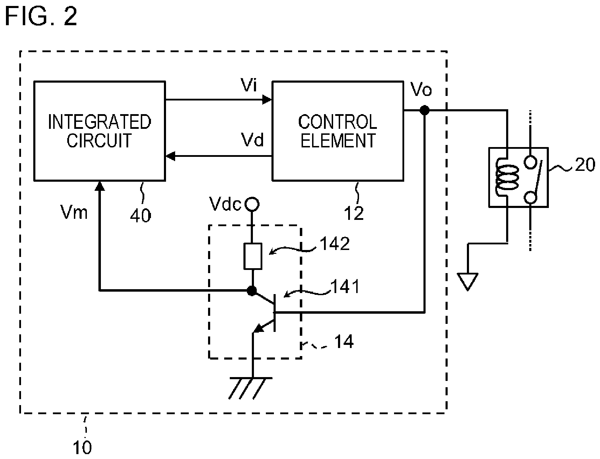

Fig. 1 is a block diagram illustrating a functional configuration of a control apparatus 10 according to a first embodiment. Fig. 2 is a diagram illustrating a hardware configuration of the control apparatus 10 according to the present embodiment. The control apparatus 10 according to the present embodiment is an apparatus that controls a relay 20. The control apparatus 10 includes a control element 12, a monitoring circuit 14, and a determination unit 16. An input signal Vi is input to the control element 12. The control element 12 outputs an output signal Vo and a diagnostic signal Vd. The monitoring circuit 14 generates an output monitor signal Vm indicating the level of the output signal Vo. The determination unit 16 determines whether or not the control apparatus 10 has an abnormality, based on a relationship between the output monitor signal Vm and the diagnostic signal Vd. Here, the output signal Vo is a signal for driving the relay 20. One terminal of the monitoring circuit 14 is electrically connected to an output terminal of the control element 12 for the output signal Vo. The diagnostic signal Vd is a signal for monitoring the state of an output destination of the output signal Vo. A detailed description will be made below.

In the example in Fig. 1, the control apparatus 10 further includes a control unit 15. The control unit 15 outputs an input signal Vi. The input signal Vi output from the control unit 15 is input to the control element 12. The control unit 15 and determination unit 16 are implemented by using an integrated circuit 40, for example. The integrated circuit 40 will be described later in detail. The input signal Vi output from the control unit 15 is also input to the determination unit 16. The determination unit 16 may acquire information indicating a signal level of the input signal Vi from the control unit 15 instead of inputting the input signal Vi to the determination unit 16. The input and output of signals and information between the control unit 15 and the determination unit 16 may be performed within the integrated circuit 40.

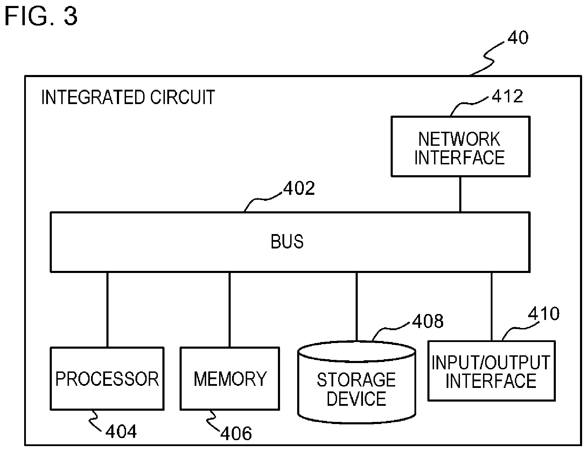

Fig. 3 is a diagram illustrating a hardware configuration of the integrated circuit 40. In Fig. 3, the control unit 15 and the determination unit 16 in the control apparatus 10 are implemented by an integrated circuit 40. The integrated circuit 40 is, for example, a system on chip (SoC).

The integrated circuit 40 includes a bus 402, a processor 404, a memory 406, a storage device 408, an input/output interface 410, and a network interface 412. The bus 402 is a data transmission line for the processor 404, the memory 406, the storage device 408, the input/output interface 410, and the network interface 412 to transmit and receive data to and from each other. A method of connecting the processors 404 and the like to each other is not limited to the bus connection. The processor 404 is an arithmetic processing unit realized using a microprocessor or the like. The memory 406 is a memory realized using a random access memory (RAM) or the like. The storage device 408 is a storage device realized using a read only memory (ROM), a flash memory, or the like.

The input/output interface 410 is an interface for connecting the integrated circuit 40 to peripheral devices. In the present embodiment, at least the control element 12 and the monitoring circuit 14 are connected to the input/output interface 410.

The network interface 412 is an interface for connecting the integrated circuit 40 to a communication network. Such a communication network is, for example, a controller area network (CAN) communication network. A method of connecting the network interface 412 to the communication network may be a wireless connection or a wired connection.

The storage device 408 stores program modules for implementing the functions of the control unit 15 and the determination unit 16, respectively. The processor 404 implements the functions of the control unit 15 and the determination unit 16 by reading the program modules into the memory 406 and executing the program modules.

The hardware configuration of the integrated circuit 40 is not limited to the configuration illustrated in Fig. 3. For example, the program module may be stored in the memory 406. In this case, the integrated circuit 40 may not include the storage device 408.

The control element 12 is implemented by an integrated circuit. The control element 12 is, for example, an intelligent power device (IPD). The control element 12 outputs an output signal Vo corresponding to the inputted input signal Vi. Furthermore, the control element 12 outputs a diagnostic signal Vd indicating the state of an output destination of the output signal Vo. In the control element 12, the diagnostic signal Vd is generated in accordance with the result of the determination using the level of the output signal Vo. The diagnostic signal Vd is input to the determination unit 16. The signal levels of the input signal Vi, the output signal Vo, and the diagnostic signal Vd are each represented by a high level or a low level based on a predetermined threshold value. The input signal Vi and the diagnostic signal Vd are, for example, binary signals. The threshold values may be different values for the input signal Vi, the output signal Vo, and the diagnostic signal Vd, respectively. The control element 12 may further have a function of detecting overheating and a protection function against overheating and overcurrent.

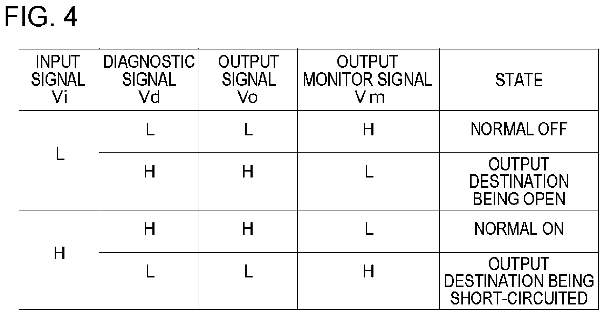

The output signal Vo output from the control element 12 is input to the relay 20. The relay 20 is turned on and off by the output signal Vo. The type of relay 20 is not particularly limited. The relay 20 may be a contact relay or a non-contact relay. The output signal Vo is also input to the monitoring circuit 14. The monitoring circuit 14 outputs the output monitor signal Vm indicating the level of the input output signal Vo. Although Fig. 2 illustrates an example in which the monitoring circuit 14 includes a resistor 142 and a transistor 141, the configuration of the monitoring circuit 14 is not limited to the present example. For example, the monitoring circuit 14 may be configured by a plurality of resistors for dividing the output signal Vo at a predetermined ratio. In this case, the output monitor signal Vm is inverted from the examples illustrated in Figs. 4 to 6. That is, "H" of the output monitor signal Vm illustrated in Figs. 4 to 6 may be read as "L", and "L" may be read as "H".

In the example in this figure, the base terminal of the transistor 141 functions as an input terminal of the monitoring circuit 14. The output terminal of the control element 12 for the output signal Vo is electrically connected to the base terminal of the transistor 141. That is, the output terminal for the output signal Vo and the base terminal of the transistor 141 have the same potential. One end of the resistor 142 is connected to the collector terminal of the transistor 141, and the constant voltage Vdc is applied to the other end of the resistor 142. On the other hand, the emitter terminal of the transistor 141 is connected to GND. The collector terminal of the transistor 141 is connected to the input/output interface 410 of the integrated circuit 40. That is, the voltage of the collector terminal of the transistor 141 is input to the determination unit 16 as the output monitor signal Vm. With such a configuration, the output monitor signal Vm indicating the level of the output signal Vo is obtained.

In particular, according to the monitoring circuit 14 in the present example, the output monitor signal Vm having a low level with respect to the output signal Vo having a high level is output, and the output monitor signal Vm having a high level with respect to the output signal Vo having a low level is output. The output monitor signal Vm having a high level has the same voltage as the constant voltage Vdc. The output signal Vo for driving the relay 20 may be at an appropriately high voltage. Here, by using the monitoring circuit 14, it is possible to convert the voltage level of the output signal Vo into a voltage level range in which the voltage can be input into the input/output interface 410 of the integrated circuit 40.

Fig. 4 is a table illustrating a relationship of each signal in the normal control apparatus 10. In Fig. 4, "L" indicates that the signal is at a low level, and "H" indicates that the signal is at a high level. In the present embodiment, the determination unit 16 can determine whether or not the output destination of the output signal Vo has an abnormality, by using the input signal Vi and the diagnostic signal Vd. Specifically, the determination unit 16 can use the input signal Vi and the diagnostic signal Vd to perform at least one of determination of whether or not the output destination of the output signal Vo is in an open state, and determination of whether or not the output destination of the output signal Vo is in a short-circuited state. The output destination of the output signal Vo include the relay 20, the monitoring circuit 14, a wiring connecting the control element 12 and the relay 20, and a wiring connecting the control element 12 and the monitoring circuit 14.

The operation of the control apparatus 10 will be described with reference to Fig. 4. First, when the relay 20 is intended to turn into an off state, an input signal Vi having a low level is input from the control unit 15 to the control element 12. Then, an output signal Vo having a low level is output from the control element 12 to the relay 20 which is normal, and then the relay 20 turns into an off state. At this time, a diagnostic signal Vd output from the control element 12 becomes a low level. Also, an output monitor signal Vm output from the monitoring circuit 14 becomes a high level.

On the other hand, when the output destination of the output signal Vo is in an open state, for example, when the relay 20 is disconnected, the output signal Vo becomes a high level with respect to the input signal Vi having a low level. Then, the diagnostic signal Vd output from the control element 12 becomes a high level, and the output monitor signal Vm becomes a low level.

When the relay 20 is intended to turn into an on state, the input signal Vi having a high level is input from the control unit 15 to the control element 12. Then, the output signal Vo having a high level is output from the control element 12 to the relay 20 which is normal, and then the relay 20 turns into an on state. At this time, the diagnostic signal Vd output from the control element 12 becomes a high level. Also, the output monitor signal Vm output from the monitoring circuit 14 becomes a low level.

On the other hand, when the output destination of the output signal Vo is in a short-circuited state, the output signal Vo becomes a low level with respect to the input signal Vi having a high level. Then, the diagnostic signal Vd output from the control element 12 becomes a low level, and the output monitor signal Vm becomes a high level. The phrase that the output destination of the output signal Vo is in a short-circuited state means that the output destination is in a short-circuited state with respect to GND. When the control element 12 has an overcurrent prevention function, the current output from the output signal Vo is limited.

In each of the states described above, the determination unit 16 determines whether or not the output destination of the output signal Vo has an abnormality, as follows, by monitoring the input signal Vi and the diagnostic signal Vd. When the input signal Vi is at a low level and the diagnostic signal Vd is at a low level, the determination unit 16 determines that the output destination of the output signal Vo has no abnormality and the relay 20 is normally turned off. When the input signal Vi is at a low level and the diagnostic signal Vd is at a high level, the determination unit 16 determines that the output destination of the output signal Vo is in an open state. When the input signal Vi is at a high level and the diagnostic signal Vd is at a high level, the determination unit 16 determines that the output destination of the output signal Vo has no abnormality and the relay 20 is normally turned off. When the input signal Vi is at a high level and the diagnostic signal Vd is at a low level, the determination unit 16 determines that the output destination of the output signal Vo is in a short-circuited state.

The determination unit 16 can determine whether or not the control element 12 and the monitoring circuit 14 have an abnormality by monitoring the diagnostic signal Vd and the output monitor signal Vm. A detailed description will be made below.

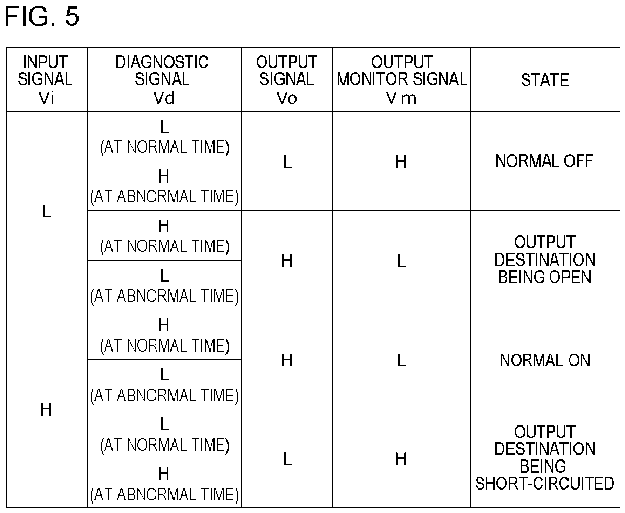

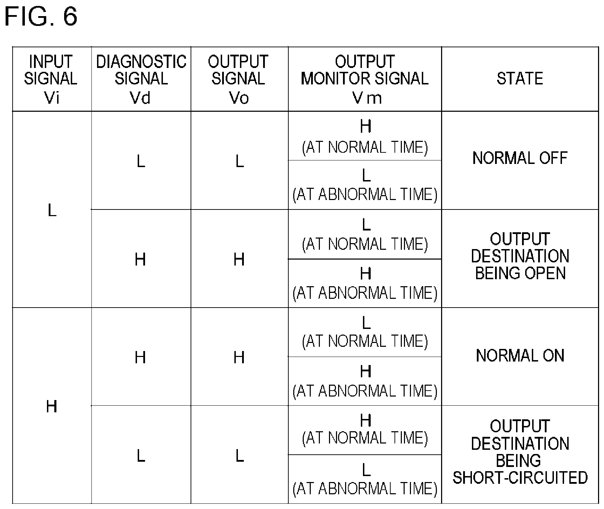

Fig. 5 is a table obtained by adding the relationship of each signal when the control element 12 has an abnormality, and the diagnostic signal Vd is not correctly output, to the table in Fig. 4. Fig. 6 is a table obtained by adding the relationship of each signal when the monitoring circuit 14 has an abnormality and the output monitor signal Vm is not correctly output, to the table in Fig. 4. In Figs. 5 and 6, "L" indicates that the signal is at a low level, and "H" indicates that the signal is at a high level. In the present example, when both the control element 12 and the monitoring circuit 14 are normal, the diagnostic signal Vd and the output monitor signal Vm normally have a reversed relationship between a high level and a low level. That is, one of the diagnostic signal Vd and the output monitor signal Vm becomes a high level, and the other becomes a low level. On the other hand, when the control element 12 has an abnormality, the diagnostic signal Vd that needs to be at a high level becomes a low level, or the diagnostic signal Vd that needs to be at a low level becomes a high level. Further, when the monitoring circuit 14 has an abnormality, the output monitor signal Vm that needs to be at a high level becomes a low level, or the output monitor signal Vm that needs to be at a low level becomes a high level. As a result, the relationship between the diagnostic signal Vd and the output monitor signal Vm becomes a matching relationship. As described above, when the relationship between the diagnostic signal Vd and the output monitor signal Vm becomes a matching relationship, the determination unit 16 determines that the control apparatus 10 has an abnormality.

The relationship of the signals in the control apparatus 10 is not limited to the examples illustrated in Figs. 4 to 6. The determination unit 16 can compare the input signal Vi and the diagnostic signal Vd, and determine whether or not the output destination of the output signal Vo has an abnormality based on whether or not the input signal Vi and the diagnostic signal Vd satisfy a predetermined relationship. Further, the determination unit 16 can compare the diagnostic signal Vd and the output monitor signal Vm, and determine whether or not the control apparatus 10 has an abnormality, based on whether or not the diagnostic signal Vd and the output monitor signal Vm satisfy a predetermined relationship. In addition, the determination unit 16 may compare the diagnostic signal Vd and the output monitor signal Vm, and further the input signal Vi, and determine whether or not the control apparatus 10 has an abnormality, based on whether or not the diagnostic signal Vd and the output monitor signal Vm, and further the input signal Vi satisfy a predetermined relationship.

As described above, the control apparatus 10 according to the present embodiment can detect an occurrence of an abnormality of the relay 20 by using the diagnostic signal Vd of the control element 12. Even when the diagnostic signal Vd of the control element 12 has a defect due to a failure of the control element 12 or the like, it is possible to detect the occurrence of an abnormality in the control apparatus 10 by using the output monitor signal Vm allowing the output signal Vo to be directly monitored. That is, the control apparatus 10 has a double abnormality detection function, and can improve the reliability of abnormality detection as compared with a case where only the diagnostic signal Vd of the control element 12 is used.

The configuration of the control element 12 is usually complicated more than the configuration of the monitoring circuit 14, and is considered to be prone to failure. Thus, when the determination unit 16 determines that an abnormality has occurred in the control apparatus 10, it may be determined that the diagnostic signal Vd is abnormal (that is, the abnormal case in Fig. 5). In this case, the determination unit 16 may determine the state of the relay 20 being the output destination of the output signal Vo, based on whether or not the relationship between the input signal Vi and the output monitor signal Vm satisfies a predetermined relationship.

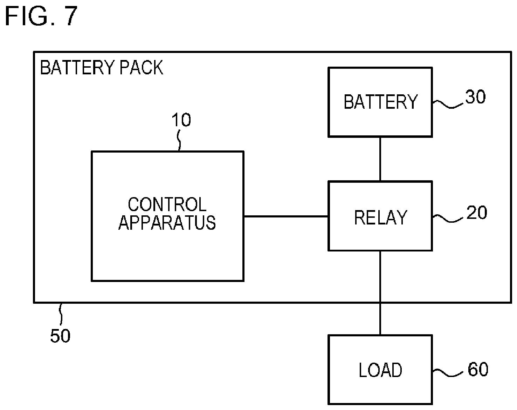

Fig. 7 is a block diagram illustrating the functional configuration of a battery pack 50 according to the present embodiment. The battery pack 50 according to the present embodiment includes the control apparatus 10, a battery 30, and the relay 20. The control apparatus 10 and relay 20 are as described above. The battery 30 is not particularly limited, but is, for example, a lithium ion battery. The battery 30 may be a battery module in which one or more battery cells are connected. A plurality of battery cells in the battery 30 may be connected in series or in parallel. In the battery 30, three or more battery cells may be connected in series and in parallel. Although the use of battery pack 50 is not particularly limited, the battery pack 50 is mounted in a moving body such as a vehicle, for example.

The battery pack 50 is connected to a load 60, and the electrical energy of the battery 30 is supplied to the load 60. At this time, the electrical connection between the battery 30 and the load 60 is turned on/off by the relay 20 controlled by the control apparatus 10. The load 60 is not particularly limited, but may be, for example, a motor drive inverter, an inverter such as a household 100V inverter, a heater, a DC-DC converter, or an air conditioner. When the battery 30 is rechargeable, the battery 30 may be configured to be connected to a charger via the relay 20 at least temporarily. The battery pack 50 according to the present embodiment includes the control apparatus 10 capable of detecting an abnormality. Therefore, when it is not possible to correctly control the power supply due to a failure of the control element 12 or the like, it can be detected that it is not possible to correctly control the power supply.

Next, the operations and effects of the present embodiment will be described. According to the control apparatus 10 according to the present embodiment, the determination unit 16 determines whether or not the control apparatus 10 has an abnormality, based on the relationship between the output monitor signal Vm and the diagnostic signal Vd. Therefore, it is possible to improve the reliability of abnormality detection as compared with the case where only the diagnostic signal Vd of the control element 12 is used.

### Second Embodiment

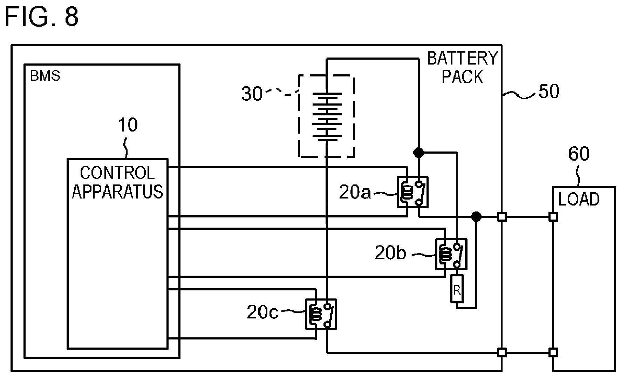

Fig. 8 is a diagram illustrating a configuration of a battery pack 50 according to a second embodiment. The battery pack 50 and a control apparatus 10 according to the present embodiment are the same as the battery pack 50 and the control apparatus 10 according to the first embodiment, except for the points described below.

The battery pack 50 according to the present embodiment includes a plurality of relays 20. The control apparatus 10 according to the present embodiment controls the plurality of relays 20. Specifically, in the example in Fig. 8, the battery pack 50 includes a relay 20a, a relay 20b, and a relay 20c. Each of the relays is the same as the relay 20 described in the first embodiment. In the example in Fig. 8, the battery 30 is a battery module in which a plurality of battery cells are connected in series. The relays 20a and 20b turn on/off the connection between the anode of the relay 20 and one terminal of the load 60, and the relay 20c turns on/off the connection between the cathode of the battery 30 and the other terminal of the load 60. The relay 20b and a resistor are connected in parallel with the relay 20a.

In the present embodiment, the control apparatus 10 is included in a battery management system (BMS). The control apparatus 10 controls each relay 20 in accordance with a predetermined sequence. As a result, a desired power supply operation or charging operation is performed while preventing an excessive current or the like.

Although Fig. 8 illustrates an example of the battery pack 50 including three relays 20, the battery pack 50 may include more relays 20.

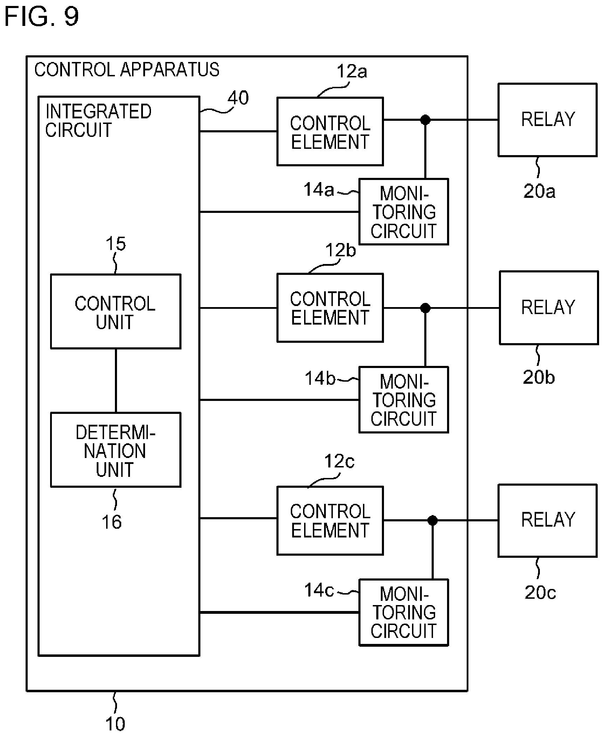

Fig. 9 is a diagram illustrating the configuration of the control apparatus 10 according to the present embodiment. In the present embodiment, the control apparatus 10 includes a plurality of control elements 12 and a plurality of monitoring circuits 14 for controlling the plurality of relays 20. Each control element 12 is the same as the control element 12 described in the first embodiment, and each monitoring circuit 14 is the same as the monitoring circuit 14 described in the first embodiment. Specifically, in the example in Fig. 9, the control apparatus 10 includes a control element 12a, a control element 12b, a control element 12c, a monitoring circuit 14a, a monitoring circuit 14b, and a monitoring circuit 14c. Each control element 12 and each monitoring circuit 14 is connected to an integrated circuit 40. The control unit 15 independently controls each control element 12 to control each relay 20 in accordance with a predetermined sequence. That is, the control unit 15 outputs the input signal Vi to each control element 12 independently. The determination unit 16 acquires the input signal Vi for each control element 12. In the example in Fig. 9, the control unit 15 outputs three input signals Vi. Three input signals Vi are input to the determination unit 16. Further, the diagnostic signal Vd output from each control element 12 and the output monitor signal Vm output from each monitoring circuit 14 are input to the determination unit 16.

Also in the present embodiment, the same operations and effects as in the first embodiment can be obtained.

Hitherto, the embodiment of the present invention has been described above with reference to the drawings, but these are examples of the present invention, and various configurations other than the above description can be adopted.

It is apparent that the present invention is not limited to the above embodiment, and may be modified and changed without departing from the scope and spirit of the invention.

## Claims

1. A control apparatus (10) that controls a relay (20), the apparatus (10) comprising:
a control element (12) that receives an input signal and outputs an output signal and a diagnostic signal;
a monitoring circuit (14) that generates an output monitor signal indicating a level of the output signal; and
a determination unit (16) that determines whether or not the control apparatus has an abnormality, based on a relationship between the output monitor signal and the diagnostic signal,
wherein the output signal is a signal for driving the relay (20),
one terminal of the monitoring circuit (14) is electrically connected to an output terminal of the control element (12) for the output signal, and
the diagnostic signal is a signal for monitoring a state of an output destination of the output signal.

2. The control apparatus (10) according to claim 1, wherein
the determination unit determines whether or not the output destination of the output signal has an abnormality, by using the input signal and the diagnostic signal.

3. The control apparatus (10) according to claim 2, wherein
the determination unit (16) performs at least one of determination of whether or not the output destination of the output signal is in an open state and determination of whether or not the output destination of the output signal is in a short-circuited state, by using the input signal and the diagnostic signal.

4. A battery pack (50) comprising:
the control apparatus (10) according to any one of claims 1 to 3;
a battery (30); and
the relay (20).
